# EUROPEAN PATENT APPLICATION

(11) **EP 4 626 148 A1**
(43) Date of publication of application: **01.10.2025**
(21) Application number: 25164185.8
(22) Date of filing: 17.03.2025
(51) Int. Cl.: H05K 1/02, H05K 1/05, H05K 3/00, H01R 12/51, H01R 12/70, H01R 13/621, H01R 9/18

(54) **ELEMENT FOR EXTRACTING HIGH-INTENSITY ELECTRIC CURRENTS FROM AN ELECTRONIC BOARD ASSEMBLED ON A METAL HEAT SINK AND MADE USING METAL SUBSTRATE TECHNOLOGY**

(30) Priority: 18.03.2024 IT 202400005905
(71) Applicant: MB Elettronica S.R.L., 52044 Cortona (Arezzo) (IT)
(72) Inventor: VALIANI, Massimo, 52045 FOIANO DELLA CHIANA AR (IT)
(74) Representative: Modiano, Micaela Nadia

(57) **Abstract**

An element (1) for extracting high-intensity electric currents from an electronic board (A) assembled on a metal heat sink (H) and made using metal substrate technology, which comprises: a main body (2) provided with a first portion (3) comprising a first internal cavity (4) and with a second portion (5) comprising a second internal cavity (6), wherein the first portion (3) and the second portion (5) are contiguous and free from material discontinuities in manufacture, and the first cavity (4) and the second cavity (6) are in communication through a through hole (7) having a diameter that is smaller than that of the cavities (4, 6); means (8) adapted for clamping an electrical cable (E) on the second portion (5); at least one first connecting element (9) adapted for passing through the through hole (7) and an opening (11) in the first, electrically-conducting layer (B), in at least one second layer made of dielectric material (C), and in at least one third, metal layer (D), with stable engagement of one terminal end thereof (12) in the metal heat sink (H);
the surface of the terminal edge (14) delimited between the outer lateral surface of the first portion (3) and the inner lateral surface of the first cavity (4) is adapted for juxtaposition with a region of the circuit of the at least one first, electrically-conducting layer (B) with consequent connection thereof in electrical continuity to the electrical circuit defined therein.

## Description

The present invention relates to an element for extracting high-intensity electric currents from an electronic board assembled on a metal heat sink and made using metal substrate technology.

Metal substrate electronic boards are electronic supports that can accommodate circuits of various kinds, adapted to condition electrical parameters such as currents and voltages, while at the same time ensuring a high capacity for dispersion of the heat generated by these parameters.

This type of electronic board (normally identified with the abbreviation IMS, meaning Insulated Metal Substrate) comprises a thin layer of thermally-conductive dielectric material (it is essential that it behaves as a very good insulator of electricity and a very poor insulator, i.e. a conductor, of heat), which is laminated between a metal base and a copper lamina (or other electrical conductor). The lamina of copper is engraved in the desired circuit model and the metal base absorbs heat from this circuit through the thin dielectric (by conduction).

These IMS boards ensure a considerably higher and more efficient dissipation of heat than what is obtainable with standard types of implementations (for example PCB boards made of epoxy glass, also known as "vetronite" or FR4, and similar materials), and this is partly in relation to the fact that the dielectric materials employed are in general 5 to 10 times more thermally conductive than normal epoxy glass.

These boards, in which the layer of dielectric material is between two metal plates, are easily damaged, if the insulation between the laminas is compromised.

The various components therefore must be connected to the board using methods that cause no damage of any kind and which preserve all the characteristics of the layer of dielectric material. This is particularly complex for components intended for the extraction of current, if the IMS board is part of an electronic power unit of a photovoltaic plant or another generation plant.

For this reason, one conventional technique entails the use of columnar elements soldered onto through holes in the board (i.e. which pass through the metal plates and the insulating layer): in such case, the current will be intercepted by the multiple holes made in the board which pass through the various layers of the board and which convey the current directly on the metal columnar element to a point of connection with the user's cable. The structure thus provided is extremely robust (because the columnar element is anchored at several points of the board) and makes it possible to extract currents of even high intensity with great efficiency.

Unfortunately however, the complexity of implementing this type of connection (in which the tabs of the columnar element need to be introduced into the through holes, without there being a direct contact between the element and the board) complicates the assembly and design of the board, thus imposing further technical constraints in the coupling with the associated heat sink.

In any case, this implementation solution is not possible if it is necessary to have an electrical insulation between the columnar element and the heat sink: in such case, it is necessary to keep the columnar element physically separate from the heat sink, which brings an increase in the dimensions and a lower efficiency of subtraction of heat from the board.

Alternatively, the use is known of screws and bolts coupled to the board which are in electrical contact (by way of insertion tabs) with the electrical circuit of the board. In this case again, the problems of isolation between the columnar element and the heat sink and the complexity of implementation are the biggest problems to be tackled.

The use is furthermore known of conductor elements directly soldered to the electrical circuit of the board: in this case, however, the intrinsic brittleness of the soldered joint is exposed to the risk of breakage during normal operational use (coupling the conducting wire to the element or releasing it from the element creates mechanical stresses which are transferred to the solder); furthermore the need to interpose a spacer body between the conductor element and the board implies more complex assembly; finally, the current carried by the conductor element is limited by the dimensions of the contact surface which is generally smaller than that available in the other cases illustrated.

The use is likewise known of mechanical stiffening techniques which involve the use of additional boards, which are kept parallel to the IMS board, to which they are interconnected electrically and mechanically by conductor elements, for example constituted by screws and bolts or soldered columnar elements.

In this manner, any stress applied to the attachment terminal of the cable (for example owing to tightening a screw or bolt) will not be transferred to the IMS board which therefore will not be damaged. Against that, however, this architecture implies considerably greater encumbrances and costs than the other techniques, with the result that it is a complex matter to transfer the current from one layer to another.

The aim of the present invention is to solve the above-mentioned drawbacks, by providing an element for extracting high-intensity electric currents from an electronic board assembled on a metal heat sink and made using metal substrate technology, that does not present insulation problems between the circuit and the heat sink lamina.

Within this aim, an object of the invention is to provide an element for extracting high-intensity electric currents from an electronic board assembled on a metal heat sink and made using metal substrate technology, that ensures an excellent electrical contact, minimizing electrical resistance, with the circuit present on the IMS board.

Another object of the invention is to provide an element for extracting high-intensity electric currents from an electronic board assembled on a metal heat sink and made using metal substrate technology, that is strong and adapted to tolerate the stresses applied to it without being damaged.

Another object of the invention is to provide an element for extracting high-intensity electric currents from an electronic board assembled on a metal heat sink and made using metal substrate technology, that offers reduced encumbrances.

Another object of the invention is to provide an element for extracting high-intensity electric currents from an electronic board assembled on a metal heat sink and made using metal substrate technology, that is capable of carrying extremely high-intensity currents.

Another object of the invention is to provide an element for extracting high-intensity electric currents from an electronic board assembled on a metal heat sink and made using metal substrate technology, that is adapted to be installed in inverters in photovoltaic plants and other electricity production/conversion plants.

Another object of the present invention is to provide an element for extracting high-intensity electric currents from an electronic board assembled on a metal heat sink and made using metal substrate technology, that is low-cost, easily and practically implemented, and safe in use.

This aim and these and other objects that will become better apparent hereinafter are achieved by an element for extracting high-intensity electric currents from an electronic board assembled on a metal heat sink and made using metal substrate technology, i.e., constituted by a structure comprising at least one first, electrically-conducting layer constituting an electrical circuit, at least one second layer made of dielectric material with high thermal conductivity, and at least one third, metal layer configured for the transfer of thermal energy, characterized in that it comprises
- a main body provided with a first portion comprising a first internal cavity and with a second portion comprising a second internal cavity, said first portion and said second portion being contiguous, said first cavity and said second cavity being connected via a through hole having a diameter that is smaller than that of said cavities,
- means adapted for clamping an electrical cable on said second portion,
- at least one first connecting element adapted for passing through said through hole, with the interposition of a spacer bushing made of dielectric material, for passing through, without contact therewith, an opening in said first, electrically-conducting layer, in at least said second layer made of dielectric material, and in at least one third, metal layer, with stable engagement of one terminal end thereof in said metal heat sink,
the surface of the terminal edge delimited between the outer lateral surface of said first portion and the inner lateral surface of said first cavity being adapted for juxtaposition with a region of the circuit of said at least one first, electrically-conducting layer with consequent connection thereof in electrical continuity to said electrical circuit defined therein.

Further characteristics and advantages of the invention will become more apparent from the detailed description that follows of a preferred, but not exclusive, embodiment of the element for extracting high-intensity electric currents from an electronic board assembled on a metal heat sink and made using metal substrate technology, which is illustrated by way of non-limiting example in the accompanying drawings wherein:
Figure 1 is a schematic perspective view of an element for extracting high-intensity electric currents from an electronic board assembled on a metal heat sink and made using metal substrate technology, according to the invention;
Figure 2 is a cross-sectional view taken along a plane of symmetry of the element of Figure 1;
Figure 3 is a schematic perspective view of a different variation of embodiment of an element for extracting high-intensity electric currents from an electronic board assembled on a metal heat sink and made using metal substrate technology, according to the invention;
Figure 4 is a cross-sectional view taken along a plane of symmetry of the element of Figure 3.

With reference to the figures, the reference numeral 1 generally designates an element for extracting high-intensity electric currents from an electronic board A with a metal substrate.

The electronic board A with metal substrate is constituted by a structure comprising at least one first, electrically-conducting layer B which constitutes an electrical circuit (the circuit from which the element 1 is to extract the current), at least one second layer made of dielectric material C with high thermal conductivity, and at least one third, metal layer D which is adapted to transfer heat energy. The third layer D is juxtaposed with a heat sink H which is designed to subtract (and dissipate in the atmosphere) heat energy from the third, metal layer D.

Above the layer B, which constitutes the electronic/electrical circuit, there can positively be an additional layer K constituted by a dielectric material, for the purpose of preventing access to the layer B, which would make an accidental contact possible (extremely dangerous for a person).

The element 1 according to the invention comprises a main body 2 provided with a first portion 3 which comprises a first internal cavity 4 and with a second portion 5 which comprises a second internal cavity 6.

The first portion 3 and the second portion 5 are contiguous and have no points of material discontinuity, therefore constituting a single continuous block.

The first cavity 4 and the second cavity 6 are connected by way of a through hole 7 having a smaller diameter than the cavities 4 and 6.

The element 1 further comprises means 8 adapted for clamping an electrical cable E on the second portion 5.

The element 1 finally comprises at least one first connecting element 9 which is adapted to pass through the through hole 7, with the interposition of a spacer bushing 10 made of dielectric material.

The first connecting element 9 furthermore passes through, without electrical contact therewith, the first, electrically-conducting layer B by virtue of the presence of an opening 11 defined in it (the breadth of which is greater than the bulk of the first element 9).

The layer K constituted by a dielectric material will be conveniently contoured to allow the coupling of electronic components to the circuit constituted by the first, electrically-conducting layer B, and also to allow the fixing (with electrical continuity) of the element 1 according to the invention.

The first connecting element 9 also passes through the at least one second layer made of dielectric material (C) and the at least one third, metal layer (D).

The end 12 of the first element 9 can in this manner engage stably in the metal heat sink H (in a respective seat 13 which is adapted especially).

The surface 14 of the terminal edge delimited between the outer lateral surface of the first portion 3 and the inner lateral surface of the first cavity 4 is adapted for juxtaposition with a region of the electronic/electrical circuit present on the first, electrically-conducting layer B with consequent connection thereof in electrical continuity to the electrical circuit defined therein.

The fixing through the first connecting element 9, engaged in the seat 13 of the metal heat sink H, ensures that the element is rigidly connected to the board A and that therefore, any mechanical stresses applied to the element 1 will not result in its accidental separation (total or partial) from the board A.

Furthermore, the fact that the element 1 is constituted by a single continuous block, preferably made of metal, ensures that it can carry high currents with minimal electrical resistance, so minimizing losses of electric energy during its transit.

With particular reference to an embodiment of undoubted practical and applicative interest, the first portion 3 of the main body 2 can comprise a perimetric frame 15 with a face 16 that can be parallel to and raised from the surface 4 of the terminal edge of the first portion 3 or substantially aligned and coplanar with the surface 4 of the terminal edge of the first portion 3.

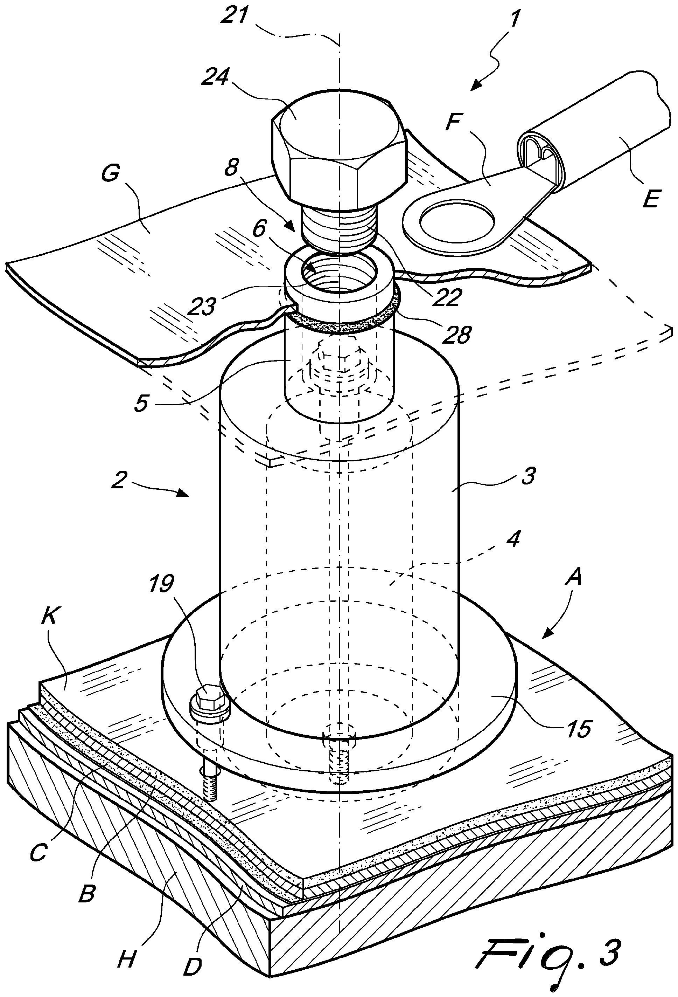

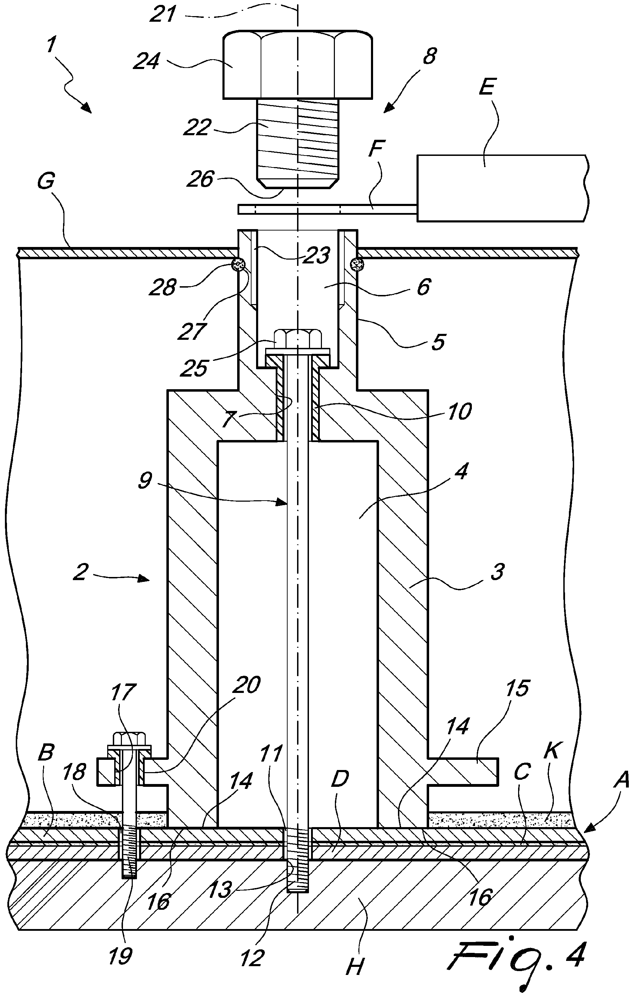

In the first configuration (shown by way of non-limiting example in the accompanying Figures 3 and 4) the frame 15 in the position raised from the surface 4 of the terminal edge of the first portion 3 makes it possible to also position on the board A, thereat, surface-mounted electrical components the height of which is less than the distance, measured along the direction of the axis of symmetry 21, of the frame 15 from the surface 4 of the terminal edge (i.e. protruding from the layer B by a predefined value): this makes it possible to maximize the use of the space on the board A. If the frame 15 were not in the raised position in fact, it would be necessary for the circuit on the layer B to have a connection region (for drawing current) that is much larger than what is generally possible (so reducing the space available on the board A to accommodate electronic components).

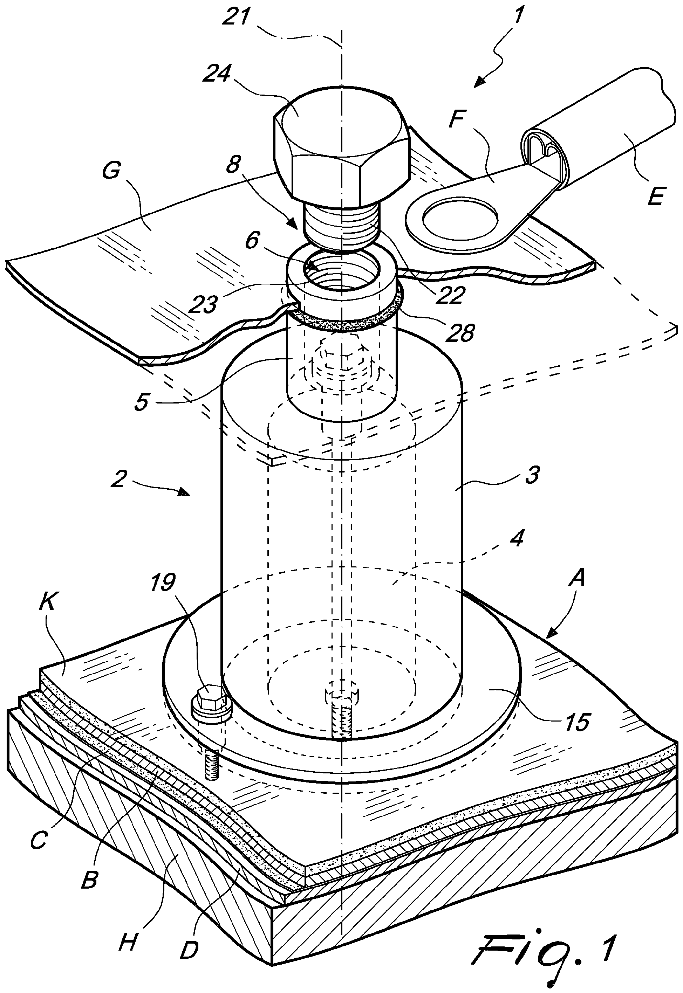

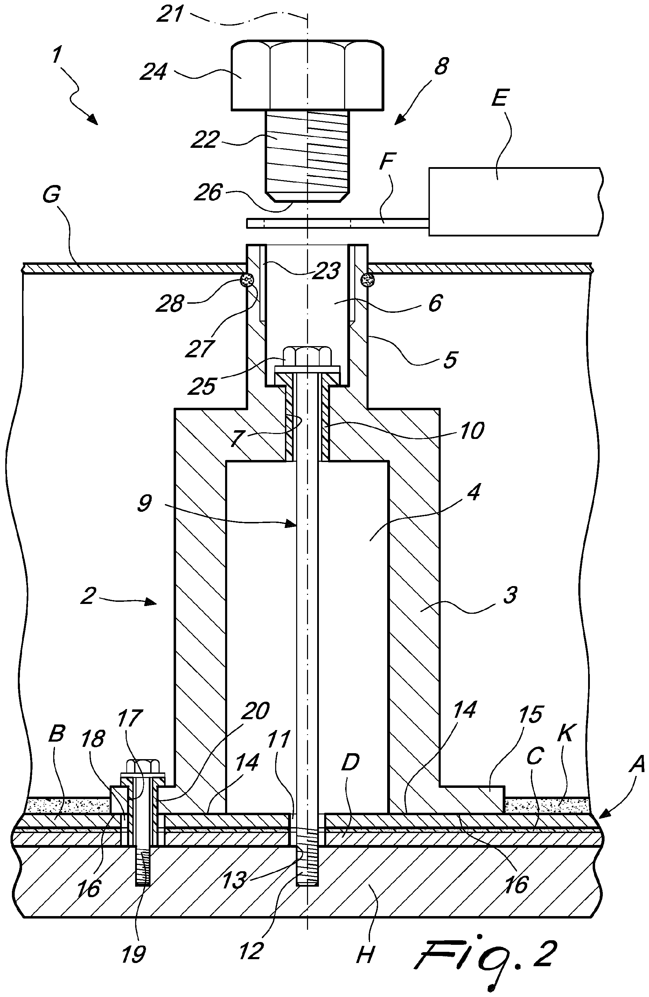

Alternatively, on the other hand, if the second implementation configuration (shown by way of non-limiting example in the accompanying Figures 1 and 2) of the frame 15 is used, the face 16 can be configured for juxtaposition with an area contiguous to the region of the electronic/electrical circuit provided on the first, electrically-conducting layer B with which the terminal edge of the first portion 3 is juxtaposed, with consequent connection in electrical continuity of such face 16 to the electrical circuit defined thereon.

In more detail, the perimetric frame 15 can advantageously comprise a through recess 17 and the first, electrically-conducting layer B can comprise a hollow 18 with dimensions not smaller than those of the recess 17 (obviously, as previously explained above, the layer K constituted by a dielectric material will also comprise respective hollows).

In the configuration of alignment of the recess 17 with the hollow 18, a second connecting element 19 can be inserted in the recess 17 and the hollow 18, as well as in corresponding openings in the layers C and D (and also in the layer K), stably engaging in the at least one metal heat sink H with consequent locking of the rotations of the main body 2 with respect to the at least one connecting element 9.

Between the second connecting element 19 and the recess 17, a sleeve 20 made of dielectric material can be interposed.

It should be noted that the spacer bushing 10 and the sleeve 20, both made of dielectric material, are preferably constituted by a fireproof material, for the purpose of guarding against any risk of fire in the event of undesired overheating (for example owing to a fault or a malfunction).

At least one part selected from the surface 14 of the terminal edge of the first portion 3 and the face 16 of the perimetric frame 15 is soldered at the electrically-conducting tracks that constitute the first, electrically-conducting layer B.

The stability of this soldered joint is ensured by the clamping of the first connecting element 9 and, where present, of the second connecting element 19. This ensures that the electrical resistance at the discontinuity surface between the electrical circuit of the first layer B and the surface 14 of the terminal edge of the first portion 3, as well as the face 16 of the perimetric frame 15, has the smallest possible value (and therefore the current can flow without particular loss of energy).

It should be noted that the main body 2 can conveniently be axially symmetrical: in this case, the first portion 3, the first internal cavity 4, the second portion 5, the second internal cavity 6 and, when present, the perimetric frame 15, will have a shape selected from cylindrical, conical, frustum-shaped and of a solid of revolution.

In this particular implementation architecture, it should be noted that the hole 7 will be arranged along the axis of symmetry 21 of the main body 2 and the first connecting element 9 will be arranged along this very axis 21.

It should further be noted that the means 8 adapted to clamp an electrical cable E onto the second portion 5 can profitably comprise a screw 22 and a threaded portion 23 of the second cavity 6.

It is therefore possible for at least one component selected from the terminal of an electrical cable E, a cable terminal F associated with an electrical cable E, a pin of an electrical connection bar, the face of an electrical connection lamina, and combinations thereof to be coupled by clamping between the head 24 of the screw 22 and the second portion 5.

It should be noted that the length of the threaded portion 23 of the second cavity 6 is shorter than the length of the entire cavity 6.

An unthreaded portion (underlying the threaded portion 23) of the second cavity 6 is advantageously adapted to accommodate the head 25 of the at least one connecting element 9 adapted to pass through the through hole 7.

In this manner, no amount of tightening of the screw 22 in the threaded portion 23 can ever bring the terminal front 26 of the screw 22 into contact with the head 25 of the element 9, so ensuring that the element 9 cannot come into contact with components that are passed through by an electric current and are therefore associated with the electrical potential of the power tracks provided on the layer B of the board A, so ensuring the electrical insulation between the element 1 and the metal heat sink H.

The possibility is not ruled out of interposing a washer of conducting material between the head of the screw 22 and the cable terminal F to improve the transfer of extracted current toward the cable E, arranged on the extraction structure.

At least one component selected from the first connecting element 9 and the second connecting element 19 can usefully be of a type selected from a screw, a threaded rod, a screw anchor and combinations thereof.

By using screws, it will be possible to proceed to tighten these using torque wrenches which offer the best assurances of quality and stability in the coupling of such screws to the metal heat sink H.

At least one component selected from the first portion 3 and the second portion 5 comprises at least one slot 27 (in the accompanying figures the slot 27 is provided on the second portion 5) on the respective lateral surface.

The slot 27 will usefully be adapted to accommodate sealing means 28 of type selected from gaskets, O-rings, D-rings, X-rings, sealing rings and combinations thereof.

Such sealing means 28 will be adapted for hermetic abutment against a surface of a protective enclosure G.

It should be noted that the main body 2 is constituted by a material selected from copper, alloys comprising copper, aluminum, alloys comprising aluminum, iron, alloys comprising iron and combinations thereof.

In particular the main body 2 will be made by stock-removal machining (for example using a turning process) starting from a continuous metal block.

Using the element 1, it is therefore possible to simplify the installation, proceeding to a corresponding surface mounting on the respective board A. Furthermore the element 1 can be applied to systems that are insulated and non-insulated with respect to the metal heat sink H for dissipating heat energy. The element 1 makes it possible to solve the problems deriving from the brittleness of conventional soldered elements when exposed to vibrations.

Using the element 1 it is furthermore possible to provide an integrated structure for transferring current without the additional use of intermediate spacer elements, so identifying a structure that is simple and compact.

The element 1 provides a structure that can be associated with electrically-insulating coverings for the assembly (such as the protective enclosure G) with a high IP grade (protection against unwanted infiltration of solids and liquids).

The simple and rapid assembly of the element 1 onto the board A ensures the costs of mounting are kept down. The element 1 is provided by machining a solid block of metal (i.e. copper, brass, more typically aluminum with its better weight/electrical conductivity/cost ratio) on which therefore there are no points of material discontinuity or soldered joints; the main body will be provided by turning and milling.

The surface 14 of the terminal edge of the first portion 3 and the face 16 of the perimetric frame 15 are conveniently polished (by turning and/or milling), so as to be perfectly flat and to ensure the best electrical contact with the circuit of the first, electrically-conducting layer B to which they are soldered. This soldered joint is provided using furnace re-melting techniques on the board A of the power converter. By calibrating the depth of the surface machining it is possible to create, for the surface 14 of the terminal edge of the first portion 3 and the face 16 of the perimetric frame 15, a sufficient cross-section for the exchange of current corresponding to the total current-carrying capacity envisaged at the design stage. The current passes through the first portion 3 (taking advantage of the broad contact surface with the circuit of the layer B ensured by the presence of the perimetric frame 15).

The tightening torque of the first connecting element 9 makes it possible to integrally clamp the element 1 to the heat sink H for dissipating heat energy, so rendering the structure strong and adapted to withstand mechanical stresses such as vibrations, torques and tangential stresses without damage; tightening the first connecting element 9 results in a transfer of such mechanical forces from the soldered joint between the surface 14 of the terminal edge of the first portion 3 and the face 16 of the perimetric frame 15 directly to the first connecting element 9 with enormous advantages of strength of the proposed solution.

In the second cavity 6 there is a threaded portion 23 which can be engaged by the screw 22 used by the user to clamp the cable terminal F for extracting the current to the cable E of the electrical system.

An important factor is the empty space (which behaves like an electrical insulation, a dielectric) between the terminal front 26 of the screw 22 and the head 25 of the first connecting element 9: with this distance, if the user at the installation stage chooses a screw 22 that is too long (something over which it is normally not possible to have total control, as it is usually carried out by persons who may not have received training), it is possible to prevent the isolation of the first connecting element 9 from being compromised. In fact, if the threaded portion 23 were longer than envisaged in the present invention, the terminal front of a screw of excessive length could touch the head 25 of the first connecting element 9; by limiting the length of the threaded portion 23, if a screw is used that is too long (longer than the screw 22 envisaged), then even by tightening it completely it would not be possible to clamp the cable terminal F of the cable E between the head 24 of the screw and the second portion 6, so requiring the installation technician to change the screw (and choose a screw 22 of the right length) or, optionally, to interpose metal washers to increase the thickness of the cable terminal F. The role of the threaded portion 23 of predefined length is precisely to arrest the tightening of a screw that is too long at a certain height, so as to create an isolation chamber between the terminal front 26 of the screw 22 and the head 25 of the connecting element 9, so as to ensure the correct electrical isolation for the type of electrical potential at play to which the element 1 is subjected with respect to the heat sink layer D. Usually these air isolation distances are defined by the technical product regulations covering the application of the converter (in which the element 1 will be installed) and it is therefore a simple matter to incorporate these at the mechanical design stage.

All the parts that are intended to carry current will be conveniently dimensioned so as to ensure that the flow of currents of predefined intensity occurs with maximum electrical efficiency (i.e. with a minimum of energy dispersion).

The slot 27 (which can also be provided by turning and/or milling) makes it possible to accommodate sealing means 28, preferably an O-ring made of silicone rubber with which to provide a coupling with the protective enclosure G of the entire structure. The presence of the O-ring (sealing means 28) ensures obtaining both an adequate IP grade (so preventing the infiltration of dust and humidity), and a mechanical absorption of the external forces to which the element 1 may be subjected.

The second connecting element 19 performs an anti-rotation function: it should be noted that there may be a greater number of connection elements 19, if it is desired to increase the mechanical strength against twisting stresses.

The element 1 according to the invention therefore has no part that is soldered/mechanically coupled (the main body 2 is provided starting from a single piece of metal subjected to stock-removal machining): this allows the transfer of current with the lowest overall electrical resistivity, therefore with less loss of electric power and with less thermal dissipation.

The element 1 according to the invention is furthermore simple to use and assemble, and is therefore particularly advantageous for users and ensures a perfect isolation of the heat sink D associated with the board A. The particular mechanical strength and robustness, demonstrated against external mechanical stresses, is a fundamentally important feature for the element 1 according to the invention, which is coupled to the board A by way of a first connecting element 9 and at least one second connecting element 19 which are configured to withstand such stresses, so freeing the soldered joint present between the main body 2 and the electrical circuit present on the layer B from this burden. The correct dimensioning of the threaded portion 23 guards against the possibility of assembly errors made by the user, thus protecting the safety of the entire apparatus fitted with the element 1.

Then, the sealing means 28 ensure the most appropriate degree of IP protection against the infiltration of solids or liquids.

Furthermore it should be noted that using the elements 1 according to the invention, the preparation work to be performed on the board A will be minimal and will be limited to making the opening 11, the hollow 18. It will furthermore also be necessary to prepare the metal heat sink H, by providing the seat 13 on it and, if necessary, an additional seat for the element 19 (the possibility is not ruled out of using, as the second connecting element 19, a self-tapping screw which might not need the preparation of a corresponding seat).

The procedure for mounting the element 1 on the board entails the following operations:
- Positioning the element 1 on the board A and passing it through a furnace to obtain the soldered joint;
- Placing the board A with standoff insulator soldered on the heat sink conductor element, of the layer D or in addition to it;
- Insertion of the connecting element 9 (with interposition of the spacer bushing 10 made of dielectric material) and tightening it (for example with a torque wrench);
- Insertion of the connecting element 19 (with interposition of the spacer bushing 20 made of dielectric material) and tightening it (for example with a torque wrench);
- Insertion of the sealing means 28 (for example a silicone O-ring);
- Insertion and centering of the protective enclosure G;
- Insertion of the screw 22 in the cable terminal F and in the threaded portion 23 of the cavity 6 and tightening it (for example with a torque wrench).

Advantageously the present invention solves the above-mentioned problems, by providing an element 1 for extracting high-intensity electric currents from an electronic board A with a metal substrate, which does not present problems of insulation between the circuit (of the layer B) and the metal heat sink H in that the connecting element 9 never comes into contact with parts that carry electric current.

Conveniently the element 1 according to the invention ensures an optimal electrical contact, while minimizing the electrical resistance, with the circuit present on the IMS board A: in fact the surface 14 of the terminal edge of the first portion 3 and the face 16 of the perimetric frame 15 are soldered to the first, electrically-conducting layer B and compressed thereon by the action of the connecting element 9.

Advantageously the element 1 according to the invention is strong and adapted to tolerate the stresses applied thereto without undergoing damage: in fact, even when tightening the screw 22 no twisting of the element 1 will occur with respect to the board A (which could cause damage to the soldered joint) because the second connecting element 19 prevents any rotation of the element 1 with respect to the axis 21 (i.e. with respect to the first connecting element 9).

Profitably the element 1 according to the invention offers reduced bulk: this makes it possible to minimize the overall bulk of the device that comprises it, which can be particularly compact, thus meeting the needs of the market.

Positively the element 1 according to the invention is capable of carrying currents of extremely high intensity: the fact that the main body 2 is made from a continuous metal block (for example by turning it) ensures the absence of discontinuity surfaces which could introduce losses or increase the electrical resistance. For this reason a current, even of extremely high intensity, can pass through the main body with high energy efficiency. Furthermore the contact between the main body and the circuit of the layer B will also be optimal, in that the juxtaposed surfaces will be soldered together and compressed against each other by the tightening of the first connecting element 9.

Usefully the element 1 according to the invention is adapted to be installed in inverters in photovoltaic plants and other electricity production/conversion plants. Such apparatuses, in fact, present a series of technical requirements that render the element 1 according to the invention an ideal component.

Positively the element 1 according to the invention is easily and practically implemented and low-cost: such characteristics make the element 1 according to the invention an innovation that is safe in use.

The invention thus conceived is susceptible of numerous modifications and variations, all of which are within the scope of the appended claims. Moreover, all the details may be substituted by other, technically equivalent elements.

In the embodiments illustrated, individual characteristics shown in relation to specific examples may in reality be interchanged with other, different characteristics, existing in other embodiments.

In practice, the materials employed, as well as the dimensions, may be any according to requirements and to the state of the art.

The disclosures in Italian Patent Application No. 102024000005905 from which this application claims priority are incorporated herein by reference.

Where technical features mentioned in any claim are followed by reference signs, those reference signs have been included for the sole purpose of increasing the intelligibility of the claims and accordingly, such reference signs do not have any limiting effect on the interpretation of each element identified by way of example by such reference signs.

## Claims

1. An element for extracting high-intensity electric currents from an electronic board (A) assembled on a metal heat sink (H) and made using metal substrate technology, i.e., constituted by a structure comprising at least one first, electrically-conducting layer (B) constituting an electrical circuit, at least one second layer made of dielectric material (C) with high thermal conductivity, and at least one third, metal layer (D) configured for a transfer of thermal energy, **characterized in that** it comprises
- a main body (2) provided with a first portion (3) comprising a first internal cavity (4) and with a second portion (5) comprising a second internal cavity (6), said first portion (3) and said second portion (5) being contiguous, said first internal cavity (4) and said second internal cavity (6) being connected via a through hole (7) having a diameter that is smaller than that of said cavities (4, 6),
- means (8) adapted for clamping an electrical cable (E) on said second portion (5),
- at least one first connecting element (9) adapted for passing through said through hole (7), with the interposition of a spacer bushing (10) made of dielectric material, for passing through, without contact therewith, an opening (11) in said first, electrically-conducting layer (B), in at least said second layer made of dielectric material (C), and in at least one third, metal layer (D), with stable engagement of one terminal end thereof (12) in said metal heat sink (H),
a surface of a terminal edge (14) delimited between an outer lateral surface of said first portion (3) and an inner lateral surface of said first cavity (4) being adapted for juxtaposition with a region of the circuit of said at least one first, electrically-conducting layer (B) with consequent connection thereof in electrical continuity to said electrical circuit defined therein.

2. The element according to claim 1, **characterized in that** said first portion (3) of said main body (2) comprises a perimetric frame (15) having a face (16) arranged according to a configuration selected from parallel to and raised and separate from the surface (4) of the terminal edge of the first portion (3) and substantially aligned and coplanar with the surface (4) of the terminal edge of the first portion (3), said perimetric frame (15) being adapted to constitute a non-coaxial anchoring with said at least one first connecting element (9) and adapted to react to the tangential stresses applied to said element (1) with respect to said board (A), so relieving from that function the mutual coupling interface between said surface of the terminal edge (14) and said corresponding region of the circuit of said at least one first, electrically-conducting layer (B).

3. The element according to one or more of the preceding claims, **characterized in that** said perimetric frame (15) comprises a through recess (17) and said first, electrically-conducting layer (B) comprises a hollow (18) with dimensions not smaller than those of said recess (17), in the configuration of alignment of said recess (17) with said hollow (18) a second connecting element (19) being insertable into said recess (17), said hollow (18) and into corresponding passages of said layers (C, D), so stably engaging in said heat sink (H) with consequent blocking of the rotations of said main body (2) with respect to said at least one connecting element (9).

4. The element according to one or more of the preceding claims, **characterized in that** at least one part selected from said surface of the terminal edge (14) of said first portion (B) and said face (16) of said perimetric frame (15) is soldered to the electrically-conducting power tracks formed in said first, electrically-conducting layer (B).

5. The element according to one or more of the preceding claims, **characterized in that** said main body (2) is axially symmetrical, said first portion (3), said first internal cavity (4), said second portion (5), said second internal cavity (6) and, when present, said perimetric frame (15), having a shape selected from cylindrical, conical, frustum-shaped and of a solid of revolution.

6. The element according to one or more of the preceding claims, **characterized in that** said means (8) adapted for clamping an electrical cable (E) on said second portion (5) comprise a screw (22) and a threaded portion (23) of said second cavity (6), it being possible for at least one component selected from the terminal of an electrical cable (E), a cable terminal (F) associated with an electrical cable (E), a pin of an electrical connection bar, the face of an electrical connection lamina, and combinations thereof to be coupled by clamping between the head (24) of said screw (22) and said second portion (5).

7. The element according to the preceding claim, **characterized in that** said threaded portion (23) of said second cavity (6) is shorter than the length of said cavity (6), an unthreaded portion of said second cavity (6) being adapted to accommodate the head (25) of the at least one first connecting element (9) adapted for passing through said through hole (7).

8. The element according to one or more of the preceding claims, **characterized in that** at least one component selected from said first connecting element (9) and said second connecting element (19) is of a type selected from a screw, a threaded rod, a screw anchor and combinations thereof.

9. The element according to one or more of the preceding claims, **characterized in that** at least one component selected from said first portion (3) and said second portion (5) comprises at least one slot (27) on the respective lateral surface, which is adapted to accommodate sealing means (28) of a type selected from gaskets, O-rings, D-rings, X-rings, sealing rings and combinations thereof, said sealing means (28) being adapted for hermetic abutment against a surface of a protective enclosure (G).

10. The element according to claim 9, **characterized in that** said main body (2) is constituted by a material selected from copper, alloys comprising copper, aluminum, alloys comprising aluminum, iron, alloys comprising iron and combinations thereof.
